# DEMANDE DE BREVET EUROPEEN

(11) **EP 3 764 393 A1**
(43) Date de publication de la demande: **13.01.2021**
(21) Numéro de dépôt: 20185217.5
(22) Date de dépôt: 10.07.2020
(51) Int. Cl.: H01L 21/762, H01L 21/033, H01L 21/308

(54) **PROCÉDÉ DE FORMATION DE TRANCHÉES**

(30) Priorité: 11.07.2019 FR 1907806
(71) Demandeur: Commissariat à l'Energie Atomique et aux Energies Alternatives, 75015 Paris (FR)
(72) Inventeur: POSSEME, Nicolas, 38054 GRENOBLE Cedex 9 (FR)
(74) Mandataire: Hautier, Nicolas

(57) **Abrégé**

Selon un aspect, on prévoit un procédé de formation des tranchées (100a) destinées à former des tranchées d'isolation, le procédé comprenant les étapes suivantes :
- Fournir un empilement comprenant au moins le substrat (10), une première couche (11) de masque dur et une deuxième couche (12) de masque dur,
- Réaliser au moins une première ouverture (111) et une deuxième ouverture (112), en effectuant des gravures isotropes ;
- Réaliser une troisième gravure, anisotrope, du substrat (10) au droit de la deuxième ouverture (112), de façon à obtenir au moins une tranchée (100a),
- Réaliser une quatrième gravure, isotrope, de la première couche (11) de façon à élargir la première ouverture (111) et obtenir une première ouverture élargie (111'),
- Réaliser une cinquième gravure, anisotrope, de façon à simultanément élargir la deuxième ouverture (112) et augmenter la profondeur de la tranchée (100a).

## Description

### DOMAINE TECHNIQUE

La présente invention concerne un procédé de réalisation de tranchées destinées à être remplies d'un matériau isolant pour former des tranchées d'isolation électrique entre composants microélectroniques. Elle trouvera pour application avantageuse la réalisation de tranchées d'isolation peu profondes appelées STI (Shallow Trench Isolation) en réduisant, voire en évitant la formation de résidus ou de défauts dans ou autour des STI.

### ÉTAT DE LA TECHNIQUE

Dans le domaine des technologies microélectroniques, l'isolation électrique latérale entre composants, notamment entre transistors, se fait généralement par des structures à base d'oxyde de silicium.

Historiquement, ces structures étaient formées par oxydation locale du silicium, et appelés LOCOS (pour LOCal Oxidation of Silicon). Face à la réduction croissante des dimensions des transistors, les structures LOCOS se sont révélées inadaptées pour l'isolation de transistors présentant des dimensions submicroniques.

En particulier, les procédés de formation de ces structures LOCOS génèrent une excroissance latérale du LOCOS, aussi connue sous le nom de « bec d'oiseau ». Cette excroissance liée à la diffusion d'espèces oxydantes sous le masque dur entraine la consommation d'une partie de la zone active. La densité surfacique d'intégration des transistors est ainsi limitée.

Un autre inconvénient des procédés de type LOCOS est la diffusion et la ségrégation du dopant Bore sous le masque dur. Cela entraîne des effets de « canaux courts » préjudiciables pour les performances du transistor.

Un autre inconvénient des procédés de type LOCOS est que la profondeur d'oxydation du silicium est directement reliée à l'espacement entre deux zones actives. Lorsque les zones actives sont proches, la profondeur de ces structures d'isolation LOCOS est réduite. Lorsqu'il existe une multitude d'espacements différents entre deux zones actives, la profondeur de ces structures d'isolation LOCOS n'est pas uniforme.

Pour pallier tous ces inconvénients, de nombreuses solutions d'intégration ont été proposées. Par exemple, le procédé SILO (pour Sealed Interface Local Oxidation) limite la diffusion de l'oxydation sous le masque dur et l'apparition du « bec d'oiseau » par une nitruration préalable à l'oxydation. Les procédés de type SWAMI (pour SideWall Mask Isolation), recourent à la gravure d'une petite tranchée d'isolation, suivie d'une oxydation de type LOCOS. Le procédé NCL (pour Nitride-Clad LOCOS) avec retrait d'oxyde sous le masque dur, suivi d'un dépôt de nitrure puis d'une oxydation locale a permis d'étendre l'isolation de type LOCOS jusqu'au nœud technologique CMOS 0,25 µm.

Cependant, à partir de ce nœud technologique, les LOCOS ont été progressivement remplacés par des tranchées d'isolation STI (pour Shallow Trench Isolation), plus performantes et beaucoup moins onéreuses que les nombreuses adaptations nécessaires des LOCOS.

Les STI se présentent sous forme de tranchées latérales séparant les transistors entre eux, remplies par dépôt d'oxyde de silicium SiO2. L'intégration des STI (aussi appelée « brique STI ») intervient au début du processus de fabrication des circuits intégrés. Les étapes de conception des STI sont illustrées et brièvement détaillées dans la suite. Typiquement, des étapes de gravures permettent de former des tranchées dans le substrat. Ces tranchées sont ensuite remplies de façon à former les STI.

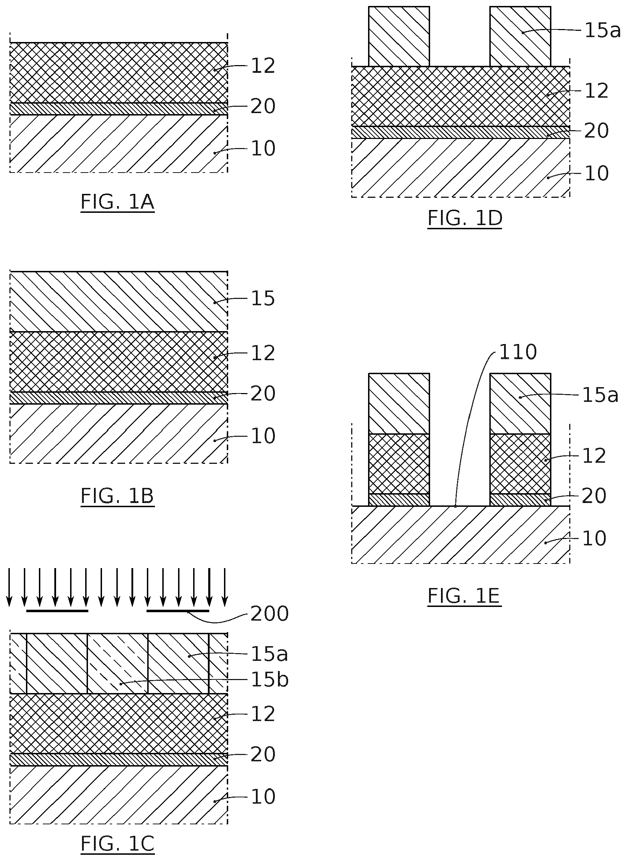

Tel qu'illustré à la figure 1A, le substrat 10 de silicium est recouvert d'un empilement de couches 20, 12 qui constituent un masque dur. Ce masque dur permet de contrôler le profil de gravure des tranchées. Le masque dur comprend typiquement une couche de SiO₂ 20 thermique (appelé oxyde piédestal ou padox d'après la terminologie anglo-saxonne) et une couche 12 plus épaisse de nitrure de silicium Si₃N₄ généralement déposée par un procédé de dépôt chimique en phase vapeur à basse pression (ou LPCVD pour Low Pressure Chemical Vapor Déposition). Des couches additionnelles d'oxyde ou de carbone amorphe (a-C :H) peuvent être ajoutées à cet empilement, de façon à optimiser la gravure des tranchées (uniformité, rugosité, profil).

Les zones de formation des STI sont ensuite définies par photolithographie (figures 1B, 1C, 1D). Une couche de résine photosensible 15 est déposée sur le l'empilement 20, 12 constituant le masque dur (Figure 1B), puis insolée à travers un masque 200 (figure 1C). Les portions 15b de résine insolées sont ensuite retirées tandis que les portions 15a de résine non modifiées sont conservées (figure 1D).

Une gravure anisotrope (figure 1E) permet d'ouvrir le masque dur et d'exposer la face avant 110 du substrat 10, entre les portions 15a.

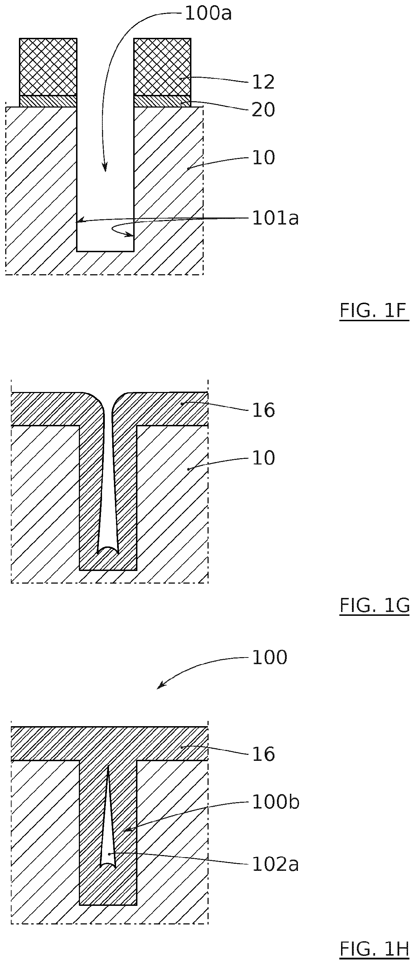

Une autre gravure anisotrope permet de former les tranchées 100a dans le substrat 10 de silicium (figure 1F). Un premier paramètre influant sur la qualité du remplissage des tranchées 100a par dépôt d'un matériau de remplissage 100b est le profil de pente des parois latérales des tranchées 100a.

Des parois latérales 101a verticales ne favorisent pas un remplissage uniforme et complet. En effet, le dépôt CVD d'oxyde SiO₂ conduit généralement dans ce cas à la formation d'épaulements dans la couche d'oxyde 16 sur le haut des tranchées (figure 1G). L'accès au fond des tranchées est ainsi réduit. Le remplissage ne se fait pas de façon optimale.

En poursuivant le dépôt d'oxyde, l'orifice d'entrée de la tranchée se referme en laissant une cavité 102a au sein du STI 100 (figure 1H).

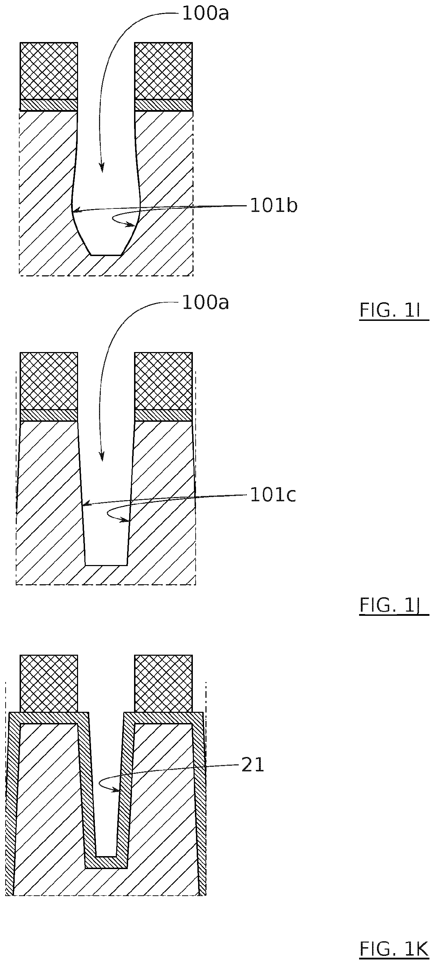

En fonction des paramètres de gravure (type de chimie utilisée, polarisation du substrat par exemple), en particulier si celle-ci n'est pas parfaitement anisotrope, des parois latérales 101b présentant un profil en tonneau peuvent également se former (figure 1I). De telles parois 101b ne favorisent pas non plus un remplissage uniforme et complet de la tranchée 100a.

Une solution pour améliorer le remplissage des tranchées 100a consiste à former des parois latérales 101c inclinées (figure 1J). Cela compense au moins en partie la formation d'épaulements en haut des tranchées. L'accès au fond des tranchées est amélioré. De telles tranchées à parois latérales inclinées présentent dès lors une largeur variable selon la profondeur. Cette variation de largeur reste néanmoins relativement faible, de l'ordre de 5 nm ou moins, et la largeur des tranchées peut être dans ce cas assimilée à une largeur moyenne.

Une solution complémentaire consiste à oxyder, généralement par traitement thermique entre 850°C à 1050°C sous atmosphère oxydante, les parois 101c et le fond des tranchées de façon à former une fine couche d'oxydation 21 appelée liner (figure 1K), préalablement au dépôt d'oxyde.

Cela permet de créer une bonne interface entre le substrat 10 et l'oxyde de remplissage 100b. Cette interface permet d'éviter la formation de défauts au niveau des parois, ces défauts pouvant perturber le fonctionnement des dispositifs finaux.

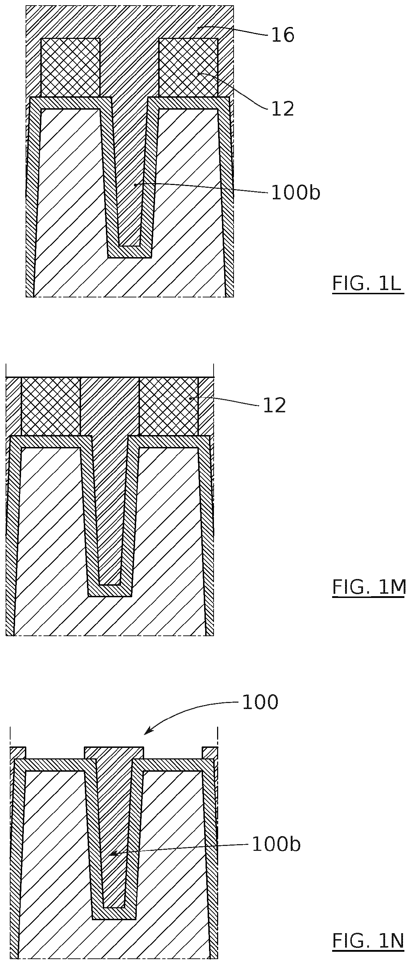

Les tranchées sont ensuite remplies avec un oxyde de remplissage 100b (figure 1L) à l'aide de techniques de dépôt chimique en phase vapeur CVD (pour Chemical Vapor Déposition). Un recuit est effectué de façon à densifier cet oxyde de remplissage 100b.

L'oxyde de remplissage en excès est retiré en partie par polissage mécano-chimique CMP (figure 1M). Le masque dur 12 est ensuite retiré de façon à exposer les zones actives où seront formés les transistors. L'excès de remplissage des tranchées est également arasé et les STI 100 sont ainsi formées (figure 1N).

La qualité des STI 100 dépend donc notamment de la qualité de l'oxyde de remplissage 100b, qui doit être dense, de la qualité de l'interface entre le silicium du substrat et l'oxyde de remplissage, qui doit être exempte de défauts, et de la qualité du remplissage lui-même, qui doit être réalisé sans qu'il y ait de formation de cavités au sein de l'oxyde de remplissage.

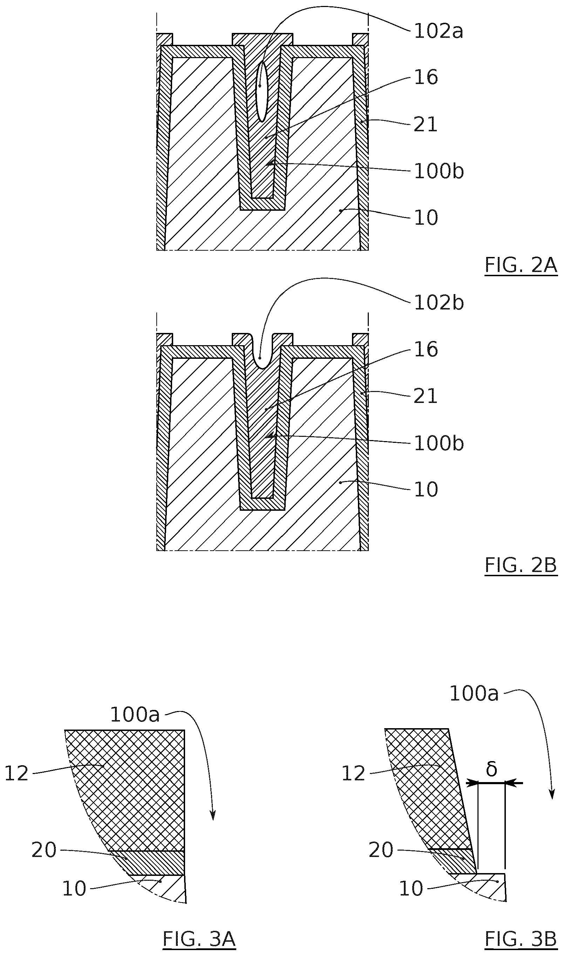

Ces cavités 102a, 102b peuvent être enterrées dans l'oxyde de remplissage (figure 2A), ou peuvent déboucher sur le haut de la tranchée (figure 2B).

Ces dernières, dites cavités ouvertes 102b, peuvent particulièrement poser problème lors des étapes de formation des grilles métalliques des transistors. Pour former ces grilles, du silicium polycristallin (poly-Si) très fortement dopé est déposé à la fois sur les zones actives et sur les STI. Il est ensuite retiré par gravure sèche sur les STI. Ce retrait est néanmoins difficile dans les cavités ouvertes de l'oxyde de remplissage. Des résidus de poly-Si peuvent subsister et relier des zones actives entre elles. Deux zones actives adjacentes normalement isolées électriquement entre elles par le STI, sont dès lors court-circuitées par une connexion électrique via ce poly-Si. Le rendement des transistors est diminué.

Les cavités enterrées 102a dans les STI sont moins critiques. Elles peuvent néanmoins évoluer vers des cavités ouvertes 102b par la suite.

Il est donc particulièrement important de développer des procédés de remplissage des tranchées d'isolation qui évitent la formation de cavités dans l'oxyde de remplissage.

En outre, ces procédés de remplissage doivent être adaptés aux évolutions de dimensions des STI. En particulier, la largeur minimum des tranchées est réduite à chaque nouveau nœud technologique et, par conséquent, le facteur de forme maximal (rapport de la profondeur d'une STI sur sa largeur) augmente.

Afin d'améliorer le remplissage de tranchées présentant une largeur réduite, une solution consiste à effectuer un retrait latéral de masque dur après gravure des tranchées et avant formation du liner (figures 3A, 3B). Ce retrait latéral est effectué par gravure humide (H₃PO₄). Il permet d'obtenir un espace supplémentaire sur une largeur δ en bordure de l'orifice d'entrée des tranchées, avant remplissage (figure 3B). Ce retrait latéral préalable permet une réduction du nombre de cavités lors du dépôt d'oxyde.

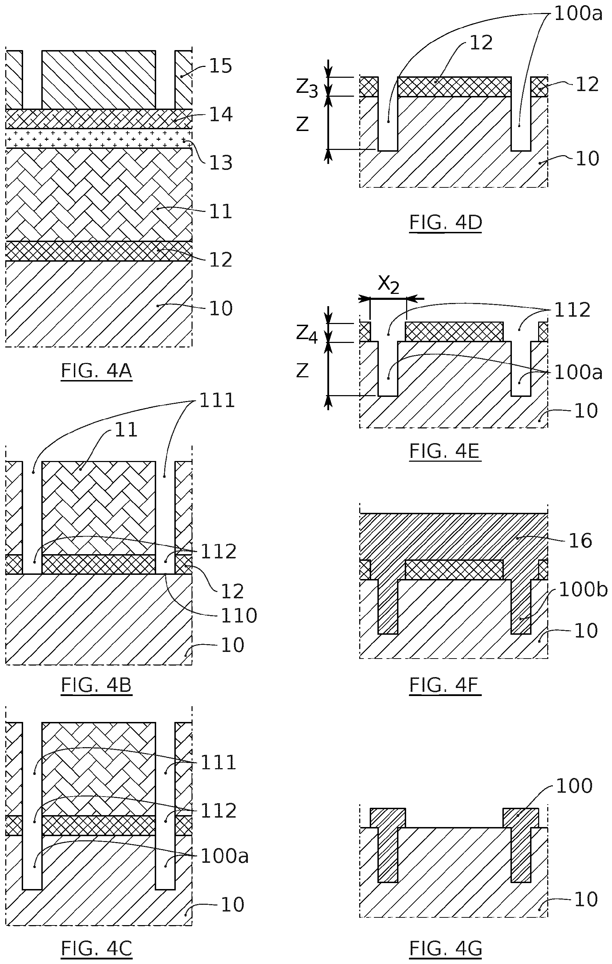

Un procédé de formation connu de STI dans un substrat de type SOI (Silicon on Insulator) permettant d'obtenir ce retrait latéral comprend les étapes successives suivantes illustrées aux figures 4A à 4G :
- Fournir un empilement comprenant au moins le substrat 10, une première couche 11 de masque dur et une deuxième couche 12 de masque dur, et éventuellement d'autres couches (par exemple anti-reflets 14) améliorant la définition et/ou la gravure des motifs de tranchées (figure 4A),
- Réaliser une gravure anisotrope de la première couche 11 de masque dur et de la deuxième couche 12 de masque dur, selon une direction principale sensiblement normale à la face avant du substrat 10, de façon à exposer au moins une partie du substrat 10 au travers d'ouvertures 111, 112 présentant une largeur x1 (figure 4B),

- Réaliser une gravure anisotrope du substrat 10 selon la direction principale, de façon à obtenir au moins une tranchée 100a présentant une profondeur Z et une largeur moyenne sensiblement égale à x1, ladite au moins une tranchée 100a s'étendant en prolongement des ouvertures 111, 112 selon la direction principale (figure 4C),
- Retirer la première couche 11 de masque dur de façon à exposer la deuxième couche 12 de masque dur présentant une épaisseur z3 et les ouvertures 112 (figure 4D),
- Réaliser une gravure isotrope de la deuxième couche 12 de masque dur de façon à élargir les ouvertures 112 pour qu'elles présentent des largeurs x2 avec x2 > x1, la deuxième couche 12 présentant une épaisseur résiduelle z4, ladite gravure isotrope étant effectuée par gravure humide à l'aide d'une solution à base d'acide phosphorique (H3PO4) (figure 4E),
- Remplir les tranchées 100a par un oxyde de remplissage 100b (figure 4F),
- Retirer un excès d'oxyde de remplissage 100b par polissage mécano-chimique, et retirer la deuxième couche 12 de masque dur, de façon à former les STI 100 (figure 4G).

Un inconvénient de ce procédé est la formation de résidus phosphorés au sein des STI ou à l'interface entre le STI 100 et le substrat 10. Ces résidus phosphorés peuvent dégrader les performances électriques des transistors.

Différentes solutions pour retirer ces résidus phosphorés ont été proposées.

Un nettoyage humide à chaud à base de NH4OH:H2O2:H2O permet de retirer ces résidus phosphorés. Ce nettoyage n'est cependant pas compatible avec des architectures de transistors basées sur du silicium-germanium (SiGe). En particulier, les zones PMOS comprenant du SiGe risquent d'être consommées par un tel nettoyage.

Un nettoyage humide à base d'acide fluorhydrique (HF) permet de retirer en partie ces résidus phosphorés. Son efficacité est cependant limitée. Ce nettoyage HF peut en outre consommer latéralement l'oxyde enterré BOX (Burried Oxyde) du substrat SOI. Cette consommation du BOX entraîne une augmentation du nombre de défauts lors du remplissage des tranchées par l'oxyde de remplissage.

La présente invention vise à pallier certains des inconvénients mentionnés ci-dessus.

Un objectif général de la présente invention consiste à réduire le risque d'apparition des cavités dans les tranchées d'isolation tout en préservant les performances électriques des transistors.

Un autre objectif de la présente invention consiste à proposer une solution pour réduire, voire pour éliminer, les résidus phosphorés lors de la formation des tranchées d'isolation dans un substrat, en particulier dans un substrat de type SOI.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre les objectifs mentionnés ci-dessus, la présente invention prévoit selon un premier aspect un procédé de formation d'au moins une tranchée destinée à être remplie d'un matériau isolant pour former une tranchée d'isolation, dans un substrat à base d'un matériau semiconducteur, l'au moins une tranchée s'étendant au sein du substrat depuis une face avant du substrat, comprenant au moins les étapes successives suivantes :
- Fournir un empilement comprenant au moins le substrat, une première couche de masque dur et une deuxième couche de masque dur, la deuxième couche étant interposée entre le substrat et la première couche ;
- Réaliser au moins une première ouverture et une deuxième ouverture s'étendant respectivement au travers de la première couche et de la deuxième couche. La première ouverture est réalisée par une première gravure, anisotrope, de la première couche, de façon à exposer au moins une partie de la deuxième couche. La deuxième ouverture est réalisée par une deuxième gravure, anisotrope, de la deuxième couche au droit de la première ouverture de sorte à exposer une partie de la face avant du substrat au droit de la deuxième ouverture ;
- Réaliser une troisième gravure, anisotrope, du substrat au droit de la deuxième ouverture, de façon à obtenir au moins une tranchée;
- Réaliser une quatrième gravure, isotrope, de la première couche de façon à élargir la première ouverture et obtenir une première ouverture élargie;
- Réaliser une cinquième gravure, anisotrope, de la deuxième couche au droit de la première ouverture élargie et du substrat au droit de la deuxième ouverture, de façon à simultanément élargir la deuxième ouverture et augmenter la profondeur de la tranchée.

Cette solution prévoit ainsi d'effectuer au moins deux gravures anisotropes du substrat (les troisième et cinquième gravures) pour former les tranchées tout en élargissant la deuxième ouverture. En particulier, la troisième gravure permet de former partiellement la tranchée dans le substrat et la cinquième gravure permet d'augmenter la profondeur de la tranchée dans le substrat, tout en élargissant la deuxième ouverture du masque dur. Cela permet d'éviter l'utilisation de chimies isotropes pour élargir la deuxième ouverture du masque dur et en particulier d'éviter l'utilisation de chimies à base de H₃PO₄.

Cette cinquième gravure présente de préférence, mais non limitativement, une sélectivité faible ou nulle (c'est-à-dire une sélectivité d'environ 1:1) entre le matériau de la deuxième couche et le matériau du substrat. Les matériaux du substrat et de la deuxième couche se gravent dès lors avec des vitesses de gravure environ égales. Cela permet de faciliter la détermination du temps de gravure nécessaire pour obtenir les profondeurs de gravure souhaitées pour la deuxième ouverture élargie et pour la tranchée approfondie. L'efficacité de la cinquième gravure est ainsi améliorée. Cela permet également d'éviter l'utilisation de chimies sélectives de ces deux matériaux et en particulier d'éviter l'utilisation de chimies à base de H₃PO₄.

Cette solution permet avantageusement d'éviter la formation de résidus phosphorés, contrairement à la solution connue pour l'élargissement de la deuxième ouverture par gravure humide à l'aide d'une solution à base d'acide phosphorique (H₃PO₄). Les étapes de nettoyage de ces résidus phosphorés préalables au remplissage des tranchées, et les inconvénients liés à ces étapes, sont donc supprimés.

Cette solution permet ainsi d'élargir la deuxième ouverture de la deuxième couche de masque dur de sorte à présenter en entrée de tranchée une section plus large pour faciliter le remplissage de la tranchée. Le remplissage de l'au moins une tranchée peut donc être amélioré.

Selon un autre aspect, on prévoit un procédé de formation d'une tranchée d'isolation comprenant la formation d'une tranchée en mettant en œuvre le procédé mentionné ci-dessus et comprenant au moins une étape de remplissage de ladite tranchée par un matériau isolant. La qualité des tranchées d'isolation, par exemple de type STI, formées après remplissage des tranchées est ainsi améliorée.

Cette solution est particulièrement avantageuse pour la formation de STI dans un substrat de type SOI (Silicon on Insulator). Cette solution est également particulièrement avantageuse pour la formation de STI dans des architectures de transistors basées sur du silicium-germanium (SiGe), et/ou pour la formation de STI dans des architectures de transistors de type FDSOI (semiconducteur sur isolant complètement déserté) ou FinFET. Cette solution est également particulièrement avantageuse pour la formation de STI présentant une largeur réduite, en particulier pour les STI formées aux nœuds technologiques les plus récents.

Cette solution est particulièrement efficace et aisément reproductible.

La présente invention propose ainsi une solution efficace face à la problématique consistant à proposer un procédé de formation de tranchées d'isolation au sein d'un substrat semiconducteur, qui améliore la réalisation de STI et les performances du dispositif.

### DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les FIGURES 1A à 1F illustrent schématiquement en coupe différentes étapes de formation d'une tranchée selon des solutions de l'art antérieur.
Les FIGURES 1G et 1H illustrent schématiquement en coupe une problématique liée au remplissage d'une tranchée telle que présentée à la FIGURE 1F.
Les FIGURES 1I et 1J illustrent schématiquement en coupe des profils de tranchée alternatifs à celui d'une tranchée telle que présentée à la FIGURE 1F. La FIGURE 1I présente un profil dit en tonneau. La FIGURE 1J présente un profil dit incliné.
Les FIGURES 1K et 1L illustrent schématiquement en coupe différentes étapes de remplissage d'une tranchée telle que présentée à la FIGURE 1J selon des solutions de l'art antérieur.
Les FIGURES 1M et 1N illustrent schématiquement en coupe différentes étapes, selon des solutions de l'art antérieur, visant à individualiser les STI telles que présentées à la FIGURE 1L, en exposant les zones actives.
Les FIGURES 2A et 2B illustrent schématiquement des cavités formées au sein de STI selon des solutions de l'art antérieur.
Les FIGURES 3A et 3B illustrent schématiquement une solution connue améliorant le remplissage des tranchées et réduisant la formation de cavités au sein des STI.
Les FIGURES 4A à 4G illustrent schématiquement en coupe différentes étapes de formation de STI selon un procédé de l'art antérieur visant à réduire la formation de cavités au sein des STI.
Les FIGURES 5A à 5F illustrent schématiquement en coupe différentes étapes de formation de tranchées selon un mode de réalisation de la présente invention.
La FIGURE 6 résume par un ordinogramme certaines étapes du mode de réalisation illustré par les FIGURES 5A à 5F.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions des différentes couches et structures (tranchées, liner) ne sont pas représentatives de la réalité. Par ailleurs, pour faciliter la compréhension de l'invention, les parois latérales des tranchées sont représentées verticales et parallèles sur les figures, alors qu'il est souhaitable que ces parois soient inclinées comme cela sera indiqué par la suite. Par souci de clarté des illustrations, certaines couches de très faible épaisseur ne sont pas nécessairement représentées.

### DESCRIPTION DÉTAILLÉE

Avant d'entamer une revue détaillée de modes de réalisation de l'invention, il est rappelé que, de manière facultative, l'invention comprend au moins l'une quelconque des caractéristiques optionnelles suivantes qui peuvent être utilisées en association ou alternativement.

Selon un exemple, l'au moins une première ouverture présente une largeur x1 dans la première couche à l'issue de la première gravure. Selon un exemple, l'au moins une deuxième ouverture présente une largeur sensiblement égale à x1 dans la deuxième couche à l'issue de la deuxième gravure et s'étend en prolongement de l'au moins une première ouverture selon la direction principale.

Selon un exemple, la tranchée réalisée dans le substrat présente également une largeur x1 puisqu'elle s'étend en prolongement de la deuxième ouverture.

Selon un exemple, à l'issue de la quatrième gravure la première ouverture est élargie est présente une largeur x2>x1. A l'issue de la cinquième gravure, la deuxième ouverture est élargie est présente une largeur égale à x2 car elle est effectuée au droit de la première ouverture élargie. Selon un exemple, les dimensions x1 et x2 sont mesurées selon une même direction, parallèle au plan principal dans lequel s'étend principalement le substrat. De préférence, cette dimension correspond à une largeur de l'ouverture. Dans ce plan parallèle au plan principal dans lequel s'étend principalement le substrat, la longueur de la tranchée correspond à la dimension la plus grande de la tranchée et la largeur correspond à une dimension perpendiculaire à la longueur.

Selon un exemple, la cinquième gravure est stoppée avant de consommer toute la deuxième couche au droit de la première ouverture élargie. Ainsi, la section de la tranchée, prise dans un plan parallèle au plan principal dans lequel s'étend principalement le substrat, correspond à la section de la deuxième ouverture non élargie.

Selon un exemple, la première gravure, anisotrope, de la première couche est réalisée selon une direction principale sensiblement normale à la face avant du substrat. Selon un exemple, la deuxième gravure, anisotrope, de la deuxième couche est réalisée selon la direction principale.

Selon un exemple, les première, deuxième, troisième et cinquième gravures sont effectuées de manière anisotrope selon une direction principale sensiblement perpendiculaire à la face avant du substrat.

Selon un exemple, le substrat est un substrat de type SOI comprenant une couche en un matériau semiconducteur, une couche de support dite bulk et une couche d'oxyde enterré dite BOX intercalée entre la couche en un matériau semiconducteur et la couche de support. Alternativement, le substrat est un substrat massif.

A l'issue de la troisième gravure la tranchée présente une profondeur z1. Selon un exemple, la deuxième couche de masque dur présente une épaisseur z3 et la cinquième gravure anisotrope est configurée de sorte à graver la deuxième couche de masque dur selon l'épaisseur z3 pendant un temps de gravure t à une vitesse de gravure v512, et à graver le substrat sur une profondeur z2 pendant le même temps de gravure t, à une vitesse de gravure v510, tel que Z = z1 + z2, Z étant la profondeur de la tranchée à l'issue de la cinquième gravure. Cela permet d'élargir la deuxième ouverture sur toute l'épaisseur de la deuxième couche tout en approfondissant la tranchée.

Selon un exemple, les vitesses de gravure v512 et v510 sont égales de sorte que z2 = z3. Cela facilite la détermination du temps de gravure t.

Selon un exemple, la vitesse de gravure v510 est supérieure à la vitesse de gravure v512 de sorte que z2 > z3. Cela permet d'optimiser l'approfondissement de la tranchée lors de la cinquième gravure.

Selon un exemple, le procédé comprend en outre, après la cinquième gravure, un retrait sélectif de la première couche de masque dur vis-à-vis de la deuxième couche de masque dur et du substrat. Cela permet de faciliter l'accès à l'entrée des tranchées pour le remplissage de celles-ci.

Selon un exemple, la deuxième couche de masque dur est à base de nitrure de silicium (SiN).

Selon un exemple, la première couche de masque dur est à base de carbone.

Selon un exemple, la première couche de masque dur est gravée lors des troisième et cinquième gravures respectivement à des troisième et cinquième vitesses de gravure v311, v511 et ces vitesses de gravure v311, v511 sont inférieures ou égales à des vitesses de gravure v310, v510 respectivement associées aux troisième et cinquième gravures du substrat. Cela permet de conserver une partie de la première couche de masque dur à l'issue des gravures permettant de former l'au moins une tranchée.

Selon un exemple, la vitesse de gravure v511 est inférieure ou égale à la vitesse de gravure v512.

Selon un exemple uniquement optionnel, la première couche de masque dur présente une épaisseur supérieure ou égale à Z + (x2-x1)/2. Dans le cas où v511≤v512≤v510 et v311≤v310, cela permet de conserver une partie de la première couche de masque dur à l'issue des gravures permettant de former l'au moins une tranchée et l'au moins une deuxième ouverture élargie.

Selon un exemple, la première gravure se fait par plasma à base d'espèces oxydantes.

Selon un exemple, les première et deuxième gravures se font par plasma à base d'espèces fluorocarbonées.

Selon un exemple, la troisième gravure se fait par plasma à base d'espèces HBr/O2.

Selon un exemple, la troisième gravure se fait par plasma à base d'espèces fluorocarbonées.

Selon un exemple, la troisième gravure se fait par plasma à base d'espèces fluorocarbonées et par plasma à base d'espèces HBr/O2, successivement.

Selon un exemple, la quatrième gravure se fait par plasma à base d'oxygène ou d'hydrogène.

Selon un exemple, la cinquième gravure se fait par plasma à base d'espèces fluorocarbonées.

Selon un exemple, le retrait sélectif se fait par plasma à base d'oxygène.

Selon un exemple, le procédé comprend en outre une étape de remplissage des tranchées par un matériau diélectrique de façon à former des STI.

Selon un exemple, au moins plusieurs des gravures et de préférence toutes les gravures sont effectuées dans un même réacteur de gravure plasma à couplage inductif ICP (Inductively Coupled Plasma).

Selon un exemple, les première et deuxième gravures sont effectuées en une seule étape.

Dans la présente demande, des étapes de gravure successives sont réalisées. Celles-ci sont numérotées pour plus de clarté. Cela ne signifie pas nécessairement que deux gravures portant deux numéros qui se suivent doivent être réalisées immédiatement l'une après l'autre. D'autres étapes ou sous-étapes peuvent être intercalées entre ces deux gravures. A l'inverse, plusieurs gravures numérotées peuvent être réalisées en une seule étape. Par exemple, les première et deuxième couches de masque dur peuvent être ouvertes par une même gravure en continu. Les numéros de gravure sont ici mentionnés à titre indicatif pour permettre un meilleur suivi de la progression du procédé selon l'invention. La compréhension du principe de fonctionnement de ce procédé est ainsi facilitée. Cela ne restreint pas ledit procédé à un nombre d'étapes déterminé.

Sauf mention explicite, il est précisé que, dans le cadre de la présente invention, la disposition relative d'une troisième couche intercalée entre une première couche et une deuxième couche, ne signifie pas obligatoirement que les couches sont directement au contact les unes des autres, mais signifie que la troisième couche est soit directement au contact des première et deuxième couches, soit séparée de celles-ci par au moins une autre couche ou au moins un autre élément.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément. En particulier, la deuxième couche de masque dur peut être généralement séparée du substrat par une fine couche d'oxyde thermique appelée padox.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, une couche à base de nitrure de silicium SiN peut par exemple comprendre du nitrure de silicium non stœchiométrique (SiN), ou du nitrure de silicium stœchiométrique (Si₃N₄), ou encore un oxy-nitrure de silicium (SiON).

Dans le cadre de la présente invention, les tranchées désignent plus particulièrement les structures obtenues après gravure, c'est-à-dire vides et sans matériau de remplissage. Les tranches isolantes ou STI désignent plus particulièrement les structures obtenues après remplissage des tranchées par le matériau de remplissage. Il est néanmoins possible que « tranchées » « tranchées isolantes » et « STI » soient employées en synonymes, par extension. L'homme du métier saura parfaitement distinguer les structures ainsi désignées.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7.

Le matériau diélectrique privilégié pour remplir les STI dans le cadre de la présente invention est le SiO2. D'autres matériaux diélectriques, tel que le SiN, peuvent toutefois être envisagés, par exemple pour d'autres applications d'isolation par des tranchées.

Les tranchées réalisées par le procédé selon l'invention sont en particulier destinées à former des tranchées d'isolation, et plus particulièrement des tranchées d'isolation peu profondes (STI). Ces dernières sont majoritaires dans les procédés de fabrication de transistors pour les nœuds technologiques les plus récents, et sont notamment utilisées pour des architectures basées sur des substrats SOI. Selon un exemple non limitatif, la profondeur des tranchées dans le silicium est de l'ordre de 200nm. Il est néanmoins possible de mettre en œuvre le procédé selon l'invention pour former d'autres types de tranchées, par exemple des tranchées d'isolation profondes dites DTI (Deep Trench Isolation).

Dans la présente demande de brevet, on parlera préférentiellement d'épaisseur pour une couche et de profondeur pour une tranchée ou une gravure. La profondeur est prise selon une direction normale à la face avant du substrat. L'épaisseur en un point de la couche est prise selon une direction normale à la tangente à la couche en ce point.

De même lorsqu'on indique qu'un élément est situé au droit d'un autre élément, cela signifie que ces deux éléments sont situés sur une même ligne perpendiculaire au plan principal dans lequel s'étend principalement une face du substrat, c'est-à-dire sur une même ligne orientée verticalement sur les figures.

La largeur est prise parallèlement à la face avant du substrat.

Les tranchées réalisées par le procédé selon l'invention présentent de préférence des parois latérales inclinées. Une inclinaison des parois latérales, c'est-à-dire des parois latérales non perpendiculaires à un plan dans lequel s'étend principalement une face du substrat, est favorable à un dépôt sans formation de vides. La pente est contrôlée en jouant sur les paramètres du plasma, notamment la quantité de gaz polymérisant. Dans ce cas, la largeur des tranchées est une largeur « moyenne » sur la profondeur des tranchées. Si les tranchées réalisées présentent des parois latérales verticales et parallèles, la largeur moyenne est simplement la largeur nominale de ces tranchées.

Dans la suite, des vitesses de gravure sont indiquées. Ces vitesses sont référencées comme suit :
Une vitesse de gravure vNcc correspond à la vitesse de gravure de la gravure n°N de la couche cc. Par exemple, v310 désigne la vitesse de gravure de la troisième gravure du substrat 10. Par exemple, v511 désigne la vitesse de gravure de la cinquième gravure de la première couche 11 de masque dur.

Dans le cas d'un substrat SOI, la vitesse de gravure de ce substrat est une vitesse de gravure moyenne à travers l'empilement. En pratique, la majeure partie de la gravure du substrat SOI correspond généralement à la gravure de la couche de support (bulk) de ce substrat SOI. La vitesse de gravure moyenne du substrat SOI est généralement donc proche de la vitesse de gravure du bulk.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

Pour déterminer la géométrie des STI, on peut procéder à des analyses de microscopie électronique, en particulier de Microscopie Electronique à Balayage (MEB) ou de Microscopie Electronique en Transmission (MET ou TEM).

Les compositions chimiques des différentes couches ou régions peuvent être déterminées à l'aide de la méthode bien connue EDX ou X-EDS, acronyme de « energy dispersive x-ray spectroscopy » qui signifie « analyse dispersive en énergie de photons X ». Cette méthode est bien adaptée pour analyser la composition de régions de faibles dimensions telles que des résidus phosphorés. Elle peut être mise en œuvre sur des coupes métallurgiques au sein d'un MEB ou sur des lames minces au sein d'un MET.

Ces techniques permettent notamment de déterminer si les STI présentent des défauts structuraux ou des cavités, et s'il y a des résidus phosphorés dans les STI.

En mettant en œuvre le procédé selon l'invention, des STI sans résidus phosphorés sont formés. L'apparition de cavités dans ces STI est également limitée ou supprimée.

De tels STI, en particulier s'ils sont formés dans un substrat SOI, peuvent donc être un indice de la mise en œuvre du procédé selon l'invention. Naturellement de nombreuses autres méthodes alternatives sont possibles pour déterminer si un dispositif a été réalisé en mettant en œuvre le procédé revendiqué.

Ce procédé permet de former les tranchées et d'élargir la deuxième ouverture sans recourir à l'utilisation de chimie à base d'espèces phosphorées, et en particulier à base de H₃PO₄. En particulier, la cinquième gravure qui a pour effet d'élargir la deuxième ouverture ne comprend pas de H₃PO₄.

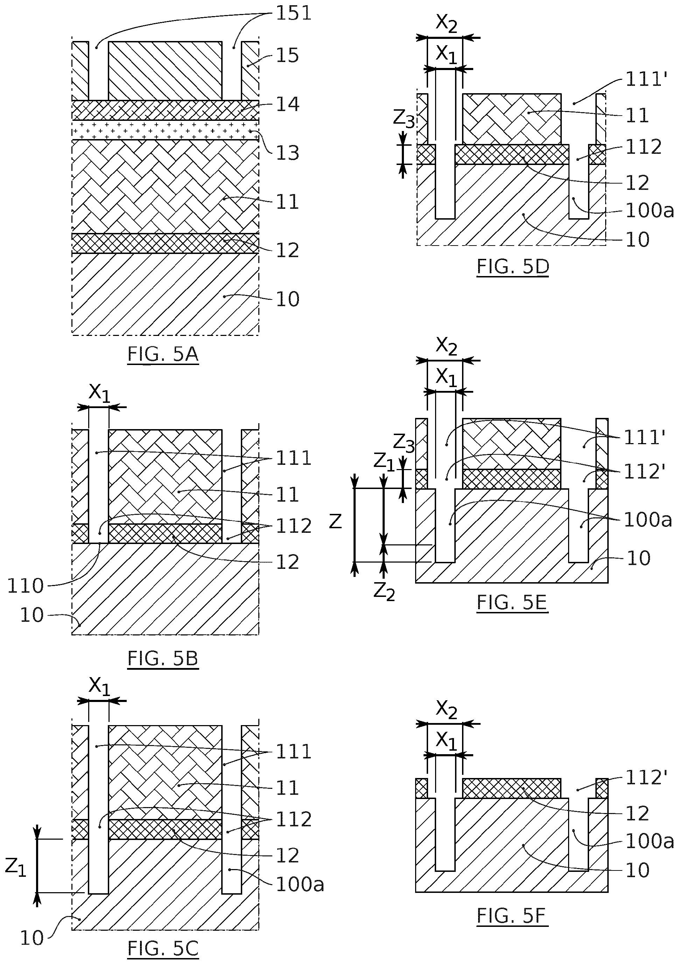

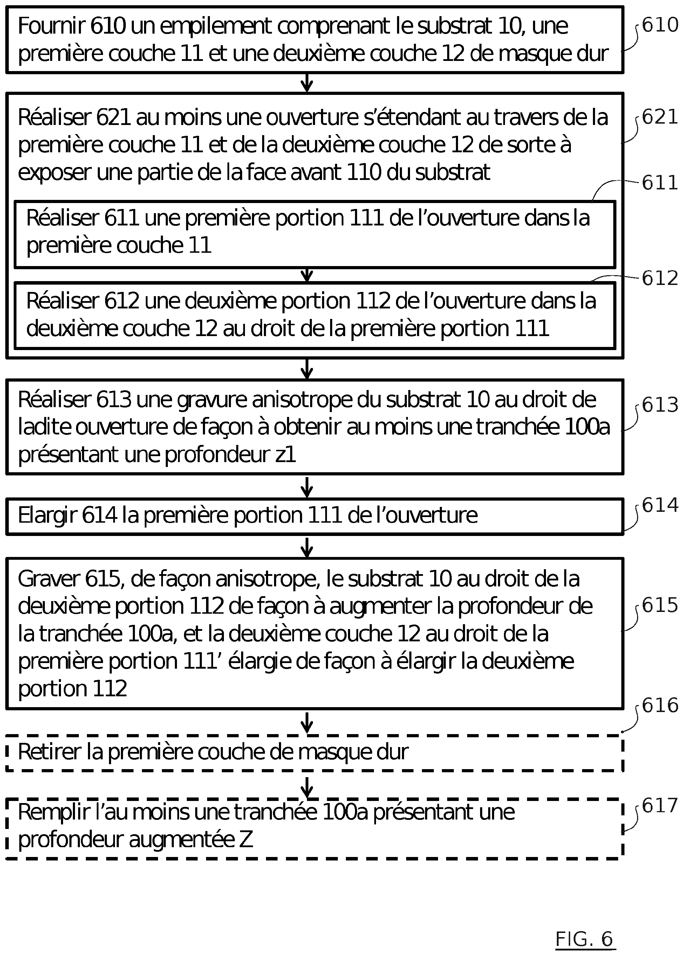

Un mode de réalisation du procédé de formation de tranchées selon l'invention va maintenant être décrit en référence aux figures 5A à 5F et à l'ordinogramme de la figure 6.

Un empilement comprenant de façon connue le substrat 10 et une succession de couches en face avant 110 du substrat 10 est d'abord fourni 610 (figure 5A, figure 6).

Cette succession de couches comprend par exemple, depuis la face avant du substrat 10, une deuxième couche 12 de masque dur, une première couche 11 de masque dur, et une troisième couche 13. Une couche anti-reflets 14 et une couche 15 de résine photosensible peuvent également surmonter cet empilement de façon à définir par photolithographie des motifs de tranchées de largeur environ égale à x1.

Ces motifs sont destinés à être transférés dans le substrat 10 par des étapes successives de gravure, de façon à former les tranchées de STI. La largeur x1 de ces motifs, et par suite, des tranchées, est de préférence comprise entre 30 nm et 100 nm, et de préférence entre 50 nm et 80 nm. La largeur x1 d'un motif est mesurée parallèlement au plan principal dans lequel s'étend principalement le substrat 10 et perpendiculairement à la longueur du motif, la longueur étant la dimension maximale du motif dans ce même plan.

A l'issue des gravures, les tranchées de STI présentent une profondeur Z. Cette profondeur Z est mesurée entre le fond de la tranchée 100a et la face avant du substrat 10 selon une direction perpendiculaire au plan principal dans lequel s'étend principalement le substrat 10. De préférence Z est comprise entre 150 nm et 300 nm. A l'issue des gravures, les tranchées de STI peuvent présenter un profil incliné, tel que décrit en introduction.

Dans ce cas, les parois latérales sont inclinées par rapport à la normale à la face du substrat 10 depuis laquelle la gravure est opérée. Comme indiqué ci-dessus, cette inclinaison des parois latérales permet de faciliter le dépôt sans formation de vides. L'inclinaison, c'est-à-dire la pente est contrôlée en jouant sur les paramètres du plasma, notamment la quantité de gaz polymérisant.

Le substrat 10 peut être un substrat élaboré de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator) ou encore un substrat silicium-germanium (SiGe) sur isolant.

Ce substrat 10 peut typiquement comprendre un support massif en silicium, une couche d'oxyde enterrée également dénommée BOX (« Burried OXide »), présentant une épaisseur par exemple comprise entre 10 nm et 200 nm, et une couche active semiconductrice à base de silicium ou de germanium. Cette couche active est de préférence en silicium (Si) ou en silicium-germanium (SiGe). Elle présente par exemple une épaisseur comprise entre 5 nm et 20 nm, de préférence entre 5 nm et 10 nm.

De façon connue, une fine couche d'oxyde, classiquement appelée padox, est de préférence formée en face avant du substrat 10. Cette couche d'oxyde peut être formée par oxydation de la couche active. Elle présente typiquement une épaisseur de l'ordre de 1 à 2 nm. Cette couche d'oxyde n'est pas représentée sur les figures. Elle est intercalée entre le substrat 10 et la deuxième couche 12 de masque dur.

La deuxième couche 12 de masque dur est de préférence à base de nitrure de silicium (SiN). Elle peut présenter une épaisseur comprise entre 30nm et 80nm.

La première couche 11 de masque dur est de préférence à base de carbone. Elle peut être déposée par centrifugation. Elle est dans ce cas appelée « Spin On Hardmask » SOH. Elle peut présenter une épaisseur comprise entre 100nm et 300nm.

La troisième couche 13 est de préférence à base d'oxy-nitrure de silicium (SiON). Elle peut présenter une épaisseur comprise entre 10nm et 40nm.

De façon connue, la couche anti-reflets 14 dénommée BARC (bottom anti-reflection coating) est typiquement utilisée en conjonction avec la couche de résine 15 pour améliorer la photolithographie.

La succession de couches présente typiquement une hauteur de plusieurs dizaines de nanomètres à plusieurs centaines de nanomètres.

Cette succession de couches est d'abord gravée par une ou plusieurs gravures anisotropes successives, selon une direction sensiblement normale à la face avant du substrat 10, de façon à exposer la face avant 110 du substrat 10.

Ces gravures anisotropes des matériaux des couches 14, 13, 11, 12 sont connues de l'homme du métier. Les paramètres principaux des gravures anisotropes et/ou isotropes sont détaillés dans la suite de la description dans les sections « gravures anisotropes » et « gravure isotrope » correspondantes.

Les motifs de tranchées 151 réalisés dans la couche 15 de résine photosensible sont typiquement transférés dans la couche BARC 14 par gravure anisotrope à l'aide d'un plasma à base d'espèces fluorocarbonées.

Ces motifs 151 peuvent ensuite être transférés dans la troisième couche SiON 13 par une gravure anisotrope semblable à la précédente, également à l'aide d'un plasma à base d'espèces fluorocarbonées.

Ces motifs 151 sont ensuite transférés dans la première couche 11 de masque dur par une première gravure 611, anisotrope (figure 5B et figure 6).

Comme illustré à la figure 5B, cette première gravure anisotrope de la première couche 11 de masque dur permet de former des premières ouvertures 111 en prolongement des motifs de tranchées et débouchant sur la deuxième couche 12 de masque dur. Ces premières ouvertures 111 présentent ainsi des largeurs sensiblement égales à x1.

De préférence la première gravure est contrôlée au temps avec un arrêt sur la face de la deuxième couche 12 tournée au regard de la première couche 11.

Cette première gravure anisotrope de la couche SOH 11 peut être effectuée en utilisant le même type de plasma à base d'espèces fluorocarbonées que précédemment. Alternativement, un plasma à base d'espèces oxydantes peut être utilisé pour réaliser cette première gravure anisotrope. Alternativement, un plasma à base d'espèces réductrices peut être utilisé pour réaliser cette première gravure anisotrope.

Les motifs sont ensuite transférés dans la deuxième couche 12 de masque dur par une deuxième gravure 612, anisotrope (figure 5B et figure 6).

Comme illustré à la figure 5B, cette deuxième gravure anisotrope de la deuxième couche 12 de masque dur, effectuée au droit des premières ouvertures 111, permet de former des deuxièmes ouvertures 112 en prolongement des premières ouvertures 111 et débouchant sur la face avant 110 du substrat 10. Ces deuxièmes ouvertures 112 présentent ainsi des largeurs sensiblement égales à x1.

La deuxième gravure peut être contrôlée au temps avec un arrêt sur la face du substrat 10 tournée au regard de la deuxième couche 10.

Cette deuxième gravure anisotrope de la couche SiN 12 peut être effectuée en utilisant le même type de plasma à base d'espèces fluorocarbonées que précédemment.

Les motifs sont ensuite transférés dans le substrat 10 par une troisième gravure 613, anisotrope (figure 5C et figure 6). Le substrat 10 et ainsi graver au droit des deuxièmes ouvertures 112.

Comme illustré à la figure 5C, cette troisième gravure permet de former des tranchées 100a en prolongement des deuxièmes ouvertures 112. Ces tranchées 100a présentent ainsi des largeurs sensiblement égales à x1, et des profondeurs sensiblement égales à z1 avec z1 < Z.

De préférence, la troisième gravure est configurée pour obtenir des tranchées 100a présentant un profil incliné et une largeur moyenne x1. Pour cela, et comme indiqué ci-dessus, on joue de préférence sur les paramètres du plasma.

Cette troisième gravure anisotrope du substrat 10 peut être effectuée en utilisant le même type de plasma à base d'espèces fluorocarbonées que précédemment. Cette troisième gravure permet notamment d'ouvrir le padox, la couche active, le BOX, et une partie du silicium bulk d'un substrat SOI.

Alternativement ou en combinaison, la gravure partielle du silicium bulk lors de cette troisième gravure peut être effectuée en utilisant un plasma à base d'espèces HBr/O2 connu de l'homme du métier.

En particulier, la troisième gravure peut être initiée par un plasma à base d'espèces fluorocarbonées, notamment pour ouvrir le BOX, puis continuée et terminée par un plasma à base d'HBr/O2, notamment pour ouvrir le silicium bulk.

La première couche 11 de masque dur est partiellement consommée lors de cette troisième gravure anisotrope. En particulier, son épaisseur diminue. Cette diminution d'épaisseur dépend notamment de la vitesse de gravure v311 associée à la troisième gravure de cette première couche 11 de masque dur.

Avantageusement, l'ensemble des première et deuxième gravures et au moins une partie de la troisième gravure, visant à ouvrir les première et deuxième couches 11, 12 de masque dur et au moins une partie du substrat 10 comprenant le BOX, peut être réalisé en une seule étape de gravure 621 (figure 6), notamment en utilisant un plasma à base d'espèces fluorocarbonées. Cela permet de réduire le nombre total d'étapes de gravure du procédé de formation des STI.

Les tranchées 100a sont ainsi partiellement formées à l'issue de cette troisième gravure. Leur profondeur z1 peut être comprise entre quelques nanomètres et quelques dizaines de nanomètres.

Cette profondeur z1 dépend notamment de la vitesse de gravure v310 associée à la troisième gravure du substrat 10.

La troisième gravure est de préférence configurée telle que v311 ≤ v310. Cela permet de consommer une épaisseur de première couche 11 de masque dur relativement plus faible que la profondeur z1.

Une quatrième gravure 614 visant à élargir les premières ouvertures 111 de la première couche 11 de masque dur est ensuite effectuée (figure 5D et figure 6).

Comme illustré à la figure 5D, cette quatrième gravure permet de former des premières ouvertures élargies 111' présentant une largeur x2 > x1. La largeur x2 est de préférence comprise entre 10 nm et 30 nm.

Cette quatrième gravure est de préférence isotrope. Elle est de préférence sélective vis-à-vis des matériaux de la deuxième couche 12 de masque dur, du liner et du substrat 10, en particulier SiN, SiO2 et Si. Cette quatrième gravure permet ainsi d'élargir uniquement les premières ouvertures 111. Elle peut être avantageusement effectuée en utilisant un plasma à base d'oxygène ou d'hydrogène.

L'épaisseur de la première couche 11 de masque dur diminue lors de cette quatrième gravure isotrope. Cette diminution d'épaisseur correspond à environ (x2-x1)/2.

L'élargissement obtenu à l'issue de cette quatrième gravure est ensuite transféré dans la deuxième couche 12 de masque dur par une cinquième gravure 615, anisotrope (figure 5E et figure 6).

Cette cinquième gravure permet d'élargir les deuxièmes ouvertures 112 en prolongement des premières ouvertures élargies 111'. Ces deuxièmes ouvertures élargies 112' présentent sensiblement la largeur x2. Cette cinquième gravure de la deuxième couche 12 de masque dur, visant à élargir les deuxièmes ouvertures 112, n'a pas besoin de graver sélectivement le matériau de la deuxième couche 12 vis-à-vis du matériau du substrat 10. Bien au contraire l'invention tire profit d'une gravure simultanée de ces deux matériaux. Cette cinquième gravure est en outre anisotrope. La solution proposée permet ainsi de se passer de chimie basée sur du H₃PO₄ ou des espèces phosphorées. La solution proposée supprime avantageusement la formation de résidus phosphorés générée par les procédés connus de formation de STI. Cette cinquième gravure anisotrope peut être effectuée en utilisant le même type de plasma à base d'espèces fluorocarbonées que précédemment.

La cinquième gravure anisotrope consomme également une partie du silicium bulk d'un substrat SOI, sur une profondeur z2, au droit des deuxième ouvertures 112.

Comme illustré à la figure 5E, la profondeur des tranchées 100a est ainsi augmentée.

La cinquième gravure est stoppée avant que toute l'épaisseur de la deuxième couche 12 de masque dur soit consommée ou tout au moins avant de commencer à consommer des portions du substrat 10 qui sont au droit de la première ouverture élargie 111' mais qui ne sont pas au droit de la première ouverture 111 avant son élargissement. Ainsi, lors de cette gravure le substrat 10 est gravé au droit de la deuxième ouverture 112 (largeur x1). Comme lors de la troisième gravure, c'est donc la section de la deuxième ouverture 112 qui définit la section de la tranchée 100a.

De préférence, à l'issue de la cinquième gravure, toute l'épaisseur de la deuxième couche 12 au droit de l'ouverture élargie 111' est consommée. Cette gravure est par exemple contrôlée au temps avec arrêt de la gravure lorsque toute l'épaisseur de la deuxième couche 12 au droit de l'ouverture élargie 111' est consommée. Au droit de la deuxième ouverture 112' élargie, la face avant du substrat 10 est alors mise à nu.

Ces tranchées 100a réalisées dans le substrat 10 présentent une largeur moyenne x1 et une profondeur Z = z1 + z2. Les tranchées 100a présentent de préférence un profil incliné à l'issue de cette cinquième gravure. Pour cela, et comme indiqué ci-dessus, on joue de préférence sur les paramètres du plasma.

La cinquième gravure anisotrope peut être configurée de façon à être faiblement sélective vis-à-vis des matériaux de la deuxième couche 12 de masque dur et du substrat 10, en particulier SiN et Si. Cela correspond à des vitesses de gravure v512 et v510 sensiblement égales. De la sorte, la profondeur de gravure supplémentaire z2 est sensiblement égale à l'épaisseur z3 de la deuxième couche 12 de masque dur, à l'issue de la cinquième gravure. Naturellement, de manière alternative, on peut prévoir que la profondeur z3 soit différente de la profondeur z2, ceci en ajustant les matériaux gravés, les solutions de gravure ainsi que la profondeur totale Z de la tranchée 100a que l'on souhaite obtenir.

De façon générale, les vitesses de gravure des différentes gravures, en particulier des troisième et cinquième gravures consommant le matériau du substrat 10 pour former les tranchées 100a, peuvent être ajustées de façon à obtenir la profondeur Z souhaitée pour les tranchées 100a tout en formant les deuxièmes ouvertures élargies 112' de largeur x2 et de profondeur z3.

La cinquième gravure anisotrope est de préférence sélective vis-à-vis du matériau du padox, en particulier SiO2. Cela permet d'éviter la formation d'un défaut de type « recess » par consommation latérale d'oxyde.

La première couche 11 de masque dur est également partiellement consommée lors de cette cinquième gravure anisotrope. En particulier, son épaisseur diminue. Cette diminution d'épaisseur dépend notamment de la vitesse de gravure v511 associée à la cinquième gravure de cette première couche 11 de masque dur.

La cinquième gravure est de préférence configurée telle que v511≤v510. Cela permet de consommer une épaisseur de première couche 11 de masque dur relativement plus faible que la profondeur z2.

Les tranchées 100a sont ainsi totalement formées à l'issue de cette cinquième gravure. Leur profondeur Z = z1 + z2 peut être comprise entre 150nm et 300nm.

A l'issue de la cinquième gravure, la deuxième couche 12 de masque dur SOH résiduelle peut être retirée 616, par exemple par plasma d'oxygène, tel qu'illustré aux figures 5F et 6.

Les étapes suivantes permettent, de façon connue, de remplir les tranchées et d'araser celles-ci de façon à former des tranchées isolantes telles que des STI. Ces étapes sont similaires à celles illustrées aux figures 4F et 4G.

Les tranchées 100a peuvent être remplies 617 par un matériau diélectrique tel qu'un oxyde de remplissage 100b (non illustré). Les deuxièmes ouvertures élargies 112' permettent d'améliorer ce remplissage.

L'excès d'oxyde de remplissage 100b peut être retiré par polissage mécano-chimique. La deuxième couche 12 de masque dur est ensuite également retirée de façon à former les tranchées isolantes 100 (non illustré).

Ce procédé de formation des tranchées isolantes permet notamment d'élargir les deuxièmes ouvertures de masque dur tout en supprimant les résidus phosphorés généralement obtenus par les procédés connus lors de cette étape d'élargissement.

La qualité des tranchées isolantes 100 ainsi formées est améliorée.

De façon avantageuse, l'ensemble des gravures est effectué au sein d'un même réacteur. Cela permet d'éviter toute oxydation parasite des différentes couches et portions entre chaque étape. Cela permet également de simplifier le procédé et de réduire les couts.

La figure 6 présente un ordinogramme reprenant de façon synthétique les principales étapes du procédé de formation de tranchées. Ce procédé comprend au moins les étapes successives suivantes :
- Fournir 610 un empilement comprenant au moins le substrat 10, une première couche 11 de masque dur et une deuxième couche 12 de masque dur, la deuxième couche 12 étant interposée entre le substrat 10 et la première couche 11,
- Réaliser 621 au moins une ouverture s'étendant au travers de la première couche 11 et de la deuxième couche 12 de sorte à exposer une partie de la face avant 110 du substrat au droit de l'ouverture, l'ouverture présentant une première portion 111 s'étendant au travers de la première couche 11 et une deuxième portion 112 s'étendant au travers de la deuxième couche 12 est au droit de la première portion 111,
- Réaliser 613 une gravure anisotrope du substrat 10 au droit de ladite ouverture et selon une direction principale sensiblement normale à la face avant du substrat 10, de façon à obtenir au moins une tranchée 100a présentant une profondeur z1,
- Elargir 614 au moins la première portion 111 de l'ouverture,
- Graver 615 la deuxième couche 12 et le substrat 10 au droit de la première portion 111 élargie, de façon anisotrope et selon la direction principale, de façon à élargir la deuxième portion 112 d'ouverture et de façon à augmenter la profondeur de la tranchée.
- De façon optionnelle, retirer 615 la première couche 11 de masque dur.

De façon optionnelle, remplir 617 l'au moins une tranchée 100a présentant une profondeur augmentée Z avec un matériau diélectrique de remplissage.

Les paragraphes suivants présentent des caractéristiques supplémentaires, optionnelles, qui peuvent être mises en œuvre dans le cadre du procédé décrit ci-dessus.

### Gravures anisotropes

Les gravures anisotropes sont effectuées selon une direction sensiblement normale à la face avant du substrat.

Ces gravures anisotropes sont effectuées par bombardement d'ions à partir d'un plasma.

Le plasma utilisé pour ces étapes de gravures anisotropes peut être à couplage capacitif (CCP) ou à couplage inductif (ICP).

Le plasma peut être à base d'espèces relativement lourdes et réactives. Les gravures anisotropes peuvent conduire à une pulvérisation des différentes couches. À cet effet, on peut utiliser des ions lourds tels que l'argon (Ar), le fluor (F) ou le brome (Br).

Afin d'obtenir des gravures anisotropes, au moins l'un des paramètres de plasma suivants est de préférence utilisé :
- La pression au sein du réacteur est inférieure à 80 milli Torr, et de préférence de l'ordre de 10 milli Torr. Cela permet d'avoir des ions principalement dirigés selon une direction normale à la face avant du substrat.
- La tension de polarisation est de préférence supérieure à 50V, de manière à accélérer et diriger les ions selon une direction normale à la face avant du substrat.

### Gravures isotropes

A contrario, les gravures isotropes sont effectuées dans toutes les directions de l'espace.

Pour favoriser des vitesses de gravure environ égales selon les directions parallèle et normale à la face avant du substrat, au moins l'un des paramètres de plasma suivants est de préférence utilisé :
- La pression au sein du réacteur est supérieure à 80 milli Torr, par exemple de l'ordre de 100 milli Torr. Cela permet d'obtenir une densité d'ions importante favorisant les collisions / répulsions entre ions.
- La tension de polarisation est de préférence nulle.

Ces paramètres ne privilégient aucune direction particulière pour le mouvement des ions.

Les conditions de gravure anisotropes et isotropes sont par exemple déterminées par simulation en utilisant des outils de simulation de type SRIM (stopping and range of ions matter) ou TRIM (transport simulation of ions in matter).

L'invention n'est pas limitée aux modes de réalisation décrits mais s'étend à tout mode de réalisation entrant dans la portée de la revendication 1

## Revendications

1. Procédé de formation d'au moins une tranchée (100a) destinée à être remplie d'un matériau isolant pour former une tranchée d'isolation, dans un substrat (10) à base d'un matériau semiconducteur, le procédé comprenant au moins les étapes successives suivantes :
- Fournir un empilement comprenant au moins le substrat (10), une première couche (11) de masque dur et une deuxième couche (12) de masque dur, la deuxième couche (12) étant interposée entre le substrat (10) et la première couche (11),
- Réaliser au moins une première ouverture (111) et une deuxième ouverture (112) s'étendant respectivement au travers de la première couche (11) et de la deuxième couche (12), la première ouverture (111) étant réalisée par une première gravure, anisotrope, de la première couche (11), de façon à exposer au moins une partie de la deuxième couche (12), la deuxième ouverture (112) étant réalisée par une deuxième gravure, anisotrope, de la deuxième couche (12) au droit de la première ouverture (111) de sorte à exposer au droit de la deuxième ouverture (112) une partie d'une face avant (110) du substrat (10),
- Réaliser une troisième gravure, anisotrope, du substrat (10) au droit de la deuxième ouverture (112), de façon à obtenir au moins une tranchée (100a) dans le substrat (10),
- Réaliser une quatrième gravure, isotrope, de la première couche (11) de façon à élargir la première ouverture (111) et obtenir une première ouverture élargie (111'),
- Réaliser une cinquième gravure, anisotrope, de la deuxième couche (12) au droit de la première ouverture élargie (111') et du substrat (10) au droit de la deuxième ouverture (112), de façon à simultanément élargir la deuxième ouverture (112) et augmenter la profondeur de la tranchée (100a),
les première et deuxième gravures et au moins une partie de la troisième gravure étant mises en œuvre en utilisant un plasma à base d'espèces fluorocarbonées.

2. Procédé selon la revendication précédente dans lequel le substrat (10) est un substrat de type SOI comprenant une couche en un matériau semiconducteur, une couche de support dite bulk et une couche d'oxyde enterré dite BOX intercalée entre la couche en un matériau semiconducteur et la couche de support.

3. Procédé selon l'une quelconque des revendications précédentes dans lequel à l'issue de la troisième gravure la tranchée (100a) présente une profondeur z1, dans lequel la deuxième couche (12) présente une épaisseur z3 et la cinquième gravure anisotrope est configurée de sorte à graver la deuxième couche (12) selon l'épaisseur z3 pendant un temps de gravure t à une vitesse de gravure v512, et à graver le substrat (10) sur une profondeur z2 pendant le même temps de gravure t, à une vitesse de gravure v510, tel que Z = z1 + z2, Z étant la profondeur de la tranchée (100a) à l'issue de la cinquième gravure.

4. Procédé selon la revendication précédente dans lequel les vitesses de gravure v512 et v510 sont égales de sorte que z2 = z3.

5. Procédé selon l'une quelconque des revendications précédentes comprenant en outre, après la cinquième gravure anisotrope, un retrait sélectif de la première couche (11) vis-à-vis de la deuxième couche (12) et du substrat (10).

6. Procédé selon l'une quelconque des revendications précédentes dans lequel la première couche (11) est gravée lors des troisième et cinquième gravures respectivement à des troisième et cinquième vitesses de gravure v311, v511 et dans lequel ces vitesses de gravure v311, v511 sont inférieures ou égales à des vitesses de gravure v310, v510 respectivement associées aux troisième et cinquième gravures du substrat (10).

7. Procédé selon l'une quelconque des revendications précédentes dans lequel la cinquième gravure est stoppée avant de consommer toute la deuxième couche (12) au droit de la première ouverture élargie (111').

8. Procédé selon l'une quelconque des revendications précédentes dans lequel la troisième gravure se fait par plasma à base de l'une au moins des familles d'espèces suivantes : des espèces à base de HBr additionnées d'O2, des espèces fluorocarbonées.

9. Procédé selon l'une quelconque des revendications précédentes dans lequel la quatrième gravure se fait par plasma à base d'oxygène ou d'hydrogène.

10. Procédé selon l'une quelconque des revendications précédentes dans lequel les deuxième et cinquième gravures se font par plasma à base d'espèces fluorocarbonées.

11. Procédé selon la revendication 5 dans lequel le retrait sélectif se fait par plasma à base d'oxygène.

12. Procédé selon l'une quelconque des revendications précédentes comprenant en outre une étape de remplissage des tranchées (100a) par un matériau diélectrique (100b).

13. Procédé selon l'une quelconque des revendications précédentes dans lequel au moins plusieurs des gravures et de préférence toutes les gravures sont effectuées dans un même réacteur de gravure plasma à couplage inductif ICP (Inductively Coupled Plasma).

14. Procédé selon l'une quelconque des revendications précédentes dans lequel les première et deuxième gravures sont effectuées en une seule étape.

15. Procédé de formation d'une tranchée d'isolation comprenant la formation d'une tranchée (100a) en mettant en œuvre le procédé selon l'une quelconque des revendications précédentes et comprenant au moins une étape de remplissage de ladite tranchée (100a) par un matériau isolant.
